# EUROPÄISCHE PATENTSCHRIFT

(11) **EP 1 485 992 B1**
(45) Veröffentlichungstag und Bekanntmachung des Hinweises auf die Patenterteilung: **15.06.2005**
(21) Anmeldenummer: 03744305.8
(22) Anmeldetag: 17.02.2003
(51) Int. Cl.: H03D 7/00, H03C 3/40

(54) **SCHALTUNGSANORDNUNG ZUR FREQUENZUMSETZUNG UND MOBILFUNKGERÄT MIT DER SCHALTUNGSANORDNUNG**
FREQUENCY CONVERTING CIRCUIT ARRANGEMENT AND MOBILE RADIO SET COMPRISING SAID CIRCUIT ARRANGEMENT
CONFIGURATION DE CIRCUIT POUR LA CONVERSION DE FREQUENCE ET APPAREIL DE TELEPHONIE MOBILE POURVU DUDIT CIRCUIT

(30) Priorität: 15.03.2002 DE 10211524
(43) Veröffentlichungstag der Anmeldung: 15.12.2004
(73) Patentinhaber: Infineon Technologies AG, 81669 München (DE)
(72) Erfinder: GREWING, Christian, 40489 Düsseldorf (DE); HANKE, André, 40489 Düsseldorf (DE)
(74) Vertreter: Epping, Hermann, Fischer
(86) Internationale Anmeldenummer: PCT/DE2003/000478
(87) Internationale Veröffentlichungsnummer: WO 2003/079537

(56) Entgegenhaltungen:
- EP-A- 1 178 604
- DE-A- 3 412 191
- DE-A- 19 819 038

## Beschreibung

Die vorliegende Erfindung betrifft eine Schaltungsanordnung zur Frequenzumsetzung und ein Mobilfunkgerät mit der Schaltungsanordnung.

Üblicherweise wird bei modernen Sende- und Empfangsanordnungen, beispielsweise im Mobilfunk, welche eine verhältnismäßig große Bandbreite aufweisen, eine komplexwertige Signalverarbeitung eingesetzt (siehe z.B. das Dokument EP 1 178 604 A). Zur Frequenzumsetzung kommen dabei in Senderichtung Quadraturmodulatoren, beispielsweise Vektormodulatoren zum Einsatz. In Empfangsrichtung, beispielsweise in einer Low-IF-Empfängerstruktur, wird das Empfangssignal mittels eines Lokaloszillatorsignals (LO-Signal) in eine verhältnismäßig geringe Zwischenfrequenzebene heruntergemischt. An Sender- und Empfängerarchitekturen mit komplexwertiger Signalverarbeitung wird die Anforderung gestellt, daß das Lokaloszillatorsignal sowie das Trägersignal als komplexwertiges Signal vorliegen müssen, das heißt aus zwei um 90° zueinander phasenverschobenen Signalkomponenten bestehen. Ein derartiges, orthogonales Signal umfaßt eine Inphase-Signalkomponente und eine Quadratur-Signalkomponente.

Herkömmliche Lokaloszillatoren, welche zur Erzeugung von Trägersignalen und Lokaloszillatorsignalen üblicherweise zum Einsatz kommen, stellen jedoch lediglich sogenannte Singleended-Signale bereit. Die somit noch erforderliche Phasenverschiebung zur Erzeugung zweier orthogonaler Signalkomponenten wird üblicherweise mit Hilfe von Phasenschiebern erzeugt, wobei die Genauigkeit der Phasenverschiebung direkten Einfluß auf die Kenndaten des Empfängers, insbesondere im Hinblick auf eine Spiegelfrequenzunterdrückung, hat.

Der Oszillator in modernen Sende- und Empfangsarchitekturen schwingt außerdem üblicherweise nicht auf der Sendefrequenz, sondern auf einer Frequenz, welche mit möglichst geringem Aufwand zur Sendefrequenz umgesetzt werden kann. Damit ist der Vorteil verbunden, daß Rückwirkungen der Sendefrequenz auf den Oszillator verringert werden können, der beispielsweise als VCO, Voltage Controlled Oscillator, ausgeführt ist.

Aufgabe der vorliegenden Erfindung ist es, eine Schaltungsanordnung zur Frequenzumsetzung anzugeben, welche das Ausgangssignal als komplexwertiges Signal bereitstellt und dabei Rückwirkungen der Ausgangsfrequenz auf die Eingangsfrequenz der Schaltung verringert. Es ist weiterhin Aufgabe der vorliegenden Erfindung, ein Mobilfunkgerät mit der Schaltungsanordnung anzugeben, welches bezüglich Spiegelfrequenzunterdrückung, Strombedarf und Phasenrauschen verbessert ist.

Erfindungsgemäß wird die Aufgabe bezüglich der Schaltungsanordnung gelöst durch eine Schaltungsanordnung zur Frequenzumsetzung, aufweisend
- einen Eingang zum Zuführen eines Eingangssignals mit einer Eingangsfrequenz,
- einen Ausgang, ausgelegt zum Abgreifen eines komplexwertigen Ausgangssignals mit einer von der Eingangsfrequenz abhängigen Ausgangsfrequenz, umfassend einen Inphase- und einen Quadraturzweig,
- einen ersten Frequenzmischer mit einem ersten Eingang, der an den Eingang der Schaltungsanordnung angeschlossen ist, mit einem zweiten Eingang und mit einem Ausgang; der mit dem Ausgang der Schaltungsanordnung gekoppelt ist,
- einen zweiten Frequenzmischer mit einem ersten Eingang, der an den Eingang der Schaltungsanordnung angeschlossen ist, mit einem zweiten Eingang und mit einem Ausgang, der mit dem Ausgang der Schaltungsanordnung gekoppelt ist, und
- einen Frequenzteiler mit einem Eingang, der mit dem Ausgang des ersten Frequenzmischers gekoppelt ist, mit einem Inphase-Ausgang, der mit dem zweiten Eingang des zweiten Frequenzmischers, und mit einem Quadratur-Ausgang, der mit dem zweiten Eingang des ersten Frequenzmischers zur Zuführung je einer Signalkomponente eines Signals mit heruntergeteilter Ausgangsfrequenz gekoppelt ist.

Gemäß vorliegendem Prinzip wird ein Eingangssignal mit einer Eingangsfrequenz in ein Ausgangssignal mit einer Ausgangsfrequenz umgesetzt, wobei die Ausgangsfrequenz abhängig ist von der Eingangsfrequenz. Das Ausgangssignal mit der Ausgangsfrequenz liegt als komplexwertiges Signal vor und umfaßt eine Inphase-Komponente und eine Quadratur-Komponente, welche zueinander orthogonal stehen. Inphase- und Quadratur-Komponente des Ausgangssignals sind demnach um 90° zueinander phasenverschoben. Das Eingangssignal wird gemäß vorliegendem Prinzip nicht in zwei Signalpfade aufgespalten, welche jeweils Eingängen von Frequenzmischern zugeführt werden. Vielmehr wird gemäß vorliegendem Prinzip das Eingangssignal lediglich je einem Eingang der Frequenzmischer zugeführt. Das Ausgangssignal mit der Ausgangsfrequenz zumindest eines der beiden Frequenzmischer wird zurückgeführt auf die jeweils zweiten Eingänge der Frequenzmischer. Es entspricht dabei dem erfindungsgemäßen Prinzip, dieses rückgeführte Signal mittels eines Frequenzteilers bezüglich der Signalfrequenz zu teilen, das heißt, den zwei Eingängen der beiden Frequenzmischer das Ausgangssignal mit heruntergeteilter Frequenz zuzuführen. Der Frequenzteiler ist dabei mit zwei zueinander orthogonalen Signalausgängen ausgebildet, so daß den Frequenzmischern das rückgeführte Signal in zwei zueinander um 90° phasenverschobenen Signalkomponenten zugeführt wird. Hierdurch sind auch die Signalkomponenten an den Ausgängen der beiden Frequenzmischer zueinander um 90° phasenverschoben und bilden zusammen das gewünschte IQ-Ausgangssignal des vorliegenden Frequenzumsetzers.

Gemäß vorliegendem Prinzip ist eine Entkopplung von Eingangsfrequenz und Ausgangsfrequenz mit geringem Aufwand sichergestellt. Zudem zeigt die beschriebene Frequenzumsetzung eine geringe Stromaufnahme sowie gute Phasenrauscheigenschaften aufgrund des einfachen Aufbaus der Frequenzumsetzungsschaltung. Die Linearitätsanforderungen an die beiden Frequenzmischer sind dabei gering, so daß dieselben zur geringen Stromaufnahme der Schaltung beitragen.

Das komplexwertige Ausgangssignal der Schaltungsanordnung kann sowohl zur Aufwärts-Frequenzumsetzung in einem Sendepfad, beispielsweise in Vektormodulatoren, wie auch zur Abwärts-Frequenzumsetzung als Lokaloszillatorsignal verwendet werden. Dabei arbeitet die beschriebene Frequenzumsetzungsschaltung bei geringem schaltungstechnischem Aufwand mit hoher Genauigkeit.

Gemäß vorliegendem Prinzip werden die orthogonalen Signalkomponenten direkt bei der Frequenzumsetzung des Eingangssignals erzeugt. Die beiden Frequenzmischer werden dabei so angesteuert, daß an ihren Ausgängen das Ausgangssignal als in IQ-Komponenten zerlegtes Signal vorliegt. Dabei wird der Frequenzrückkopplungszweig des Frequenzumsetzers ausgenutzt. Die Genauigkeit der Phasenlage des Ausgangssignals beziehungsweise dessen Komponenten ist gemäß vorliegendem Prinzip nicht von RC-Toleranzen, das heißt von Fertigungstoleranzen integrierter Bauteile abhängig und zudem Frequenz-unabhängig. Weiterhin haben zwei Frequenzmischer gemeinsam eine deutlich geringere Stromaufnahme als ein Frequenzmischer und ein beispielsweise als RC-Allpaß ausgebildeter, üblicherweise vorgesehener Phasenschieber.

Die beiden Frequenzmischer der Frequenzumsetzungsschaltung sind bevorzugt als Aufwärts-Frequenzmischer ausgelegt.

Der Frequenzteiler ist bevorzugt als Frequenzteiler mit dem Teilerfaktor 2 ausgebildet. In diesem Fall entspricht die Eingangsfrequenz der 1,5-fachen Ausgangsfrequenz, das heißt, daß ein an den Eingang der Frequenzumset zungsschaltung angeschlossener Oszillator bei der 1,5-fachen gewünschten Ausgangsfrequenz schwingt. Frequenzteiler mit dem Teilerfaktor 2 sind in besonders einfacher Weise realisierbar.

In einer besonders bevorzugten Ausführungsform ist der Frequenzteiler als Flipflop-Baustein ausgebildet mit zwei orthogonalen Ausgängen, welche je einen der beiden Frequenzmischer ansteuern. Ein derartiges Flipflop ist ein Standard-Bauteil der integrierten Hochfrequenztechnik und ermöglicht in einfacher Weise die im Rückkopplungszwei gemäß vorliegendem Prinzip vorgesehene Frequenzteilung durch zwei und die Signalaufspaltung in orthogonale Komponenten, welche zur Ansteuerung der beiden Frequenzmischer vorgesehen sind.

Dabei ist ein Ausgang eines der beiden Frequenzmischer bevorzugt zur Bildung des Rückkopplungspfades mit dem Takteingang des Flipflops gekoppelt.

Zwischen den Ausgang der Frequenzmischer und den Ausgang der Schaltung und damit zwischen den Ausgang eines der beiden Frequenzmischer und den Eingang des Frequenzteilers ist bevorzugt je ein Mittel zur Gleichanteilentkopplung des Ausgangssignals geschaltet. Das Mittel zur Gleichanteilentkopplung ist bevorzugt als Serienkondensator ausgebildet und unterdrückt die gemäß vorliegendem Prinzip gegebenenfalls auftretenden DC-Komponenten im Ausgangssignal, welche durch die Frequenzmischung entstehen können.

Bezüglich des Mobilfunkgerätes wird die Aufgabe gelöst durch ein Mobilfunkgerät mit einer Schaltungsanordnung mit den Merkmalen wie vorstehend beschrieben, aufweisend
- zumindest eine Einrichtung zur Frequenzumsetzung eines Nutzsignals zwischen einem Basisband und einer hochfrequenten Lage mit einem Hilfseingang zum Zuführen eines komplexwertigen Signals mit einer Trägerfrequenz,
- einen Frequenzgenerator, der an einem Ausgang ein Bezugssignal mit einer Bezugsfrequenz bereitstellt, und
- die Schaltungsanordnung zur Frequenzumsetzung, die mit ihrem Eingang an den Ausgangs des Frequenzgenerators und mit ihrem Ausgang mit dem Hilfseingang der Einrichtung zur Frequenzumsetzung gekoppelt ist.

Wie bereits angedeutet, ist die vorliegende Frequenzumsetzungsschaltung besonders zur Ansteuerung von Frequenzumsetzern, Modulatoren und Demodulatoren in Mobilfunkgeräten geeignet. Dabei ist an den Eingang der Schaltungsanordnung ein Frequenzgenerator, beispielsweise ein VCO, angeschlossen. Der Ausgang der Schaltung ist mit einer Einrichtung zur Frequenzumsetzung eines Nutzsignals verbunden. Da die vorliegende Frequenzumsetzungsschaltung sowohl zur Ansteuerung von Frequenzumsetzern in Sende- als auch in Empfangspfaden von Mobilfunkgeräten geeignet ist, kann der Ausgang der Schaltungsanordnung zur Frequenzumsetzung sowohl an einen Eingang eines Aufwärts-Frequenzmischers in einem Sendepfad, als auch an den Eingang eines Abwärts-Frequenzmischers in einem Empfangspfad angeschlossen sein.

Mit dem beschriebenen Mobilfunkgerät ist eine produktionsunabhängige und frequenzgenaue Bereitstellung von Trägerfrequenzen und Lokaloszillatorfrequenzen als IQ-Signal mit geringem Aufwand und zugleich die Auslegung von Sende- und/oder Empfangsarchitekturen mit komplexwertiger Signalverarbeitung eines Nutzsignals ermöglicht.

Es zeigen:
- Figur 1: anhand eines vereinfachten Blockschaltbildes ein Ausführungsbeispiel der Frequenzumsetzungsschaltung gemäß vorliegendem Prinzip und
- Figur 2: anhand eines vereinfachten Blockschaltbildes ein Ausführungsbeispiel eines Mobilfunkgerätes mit einer Frequenzumsetzungsschaltung gemäß Figur 1.

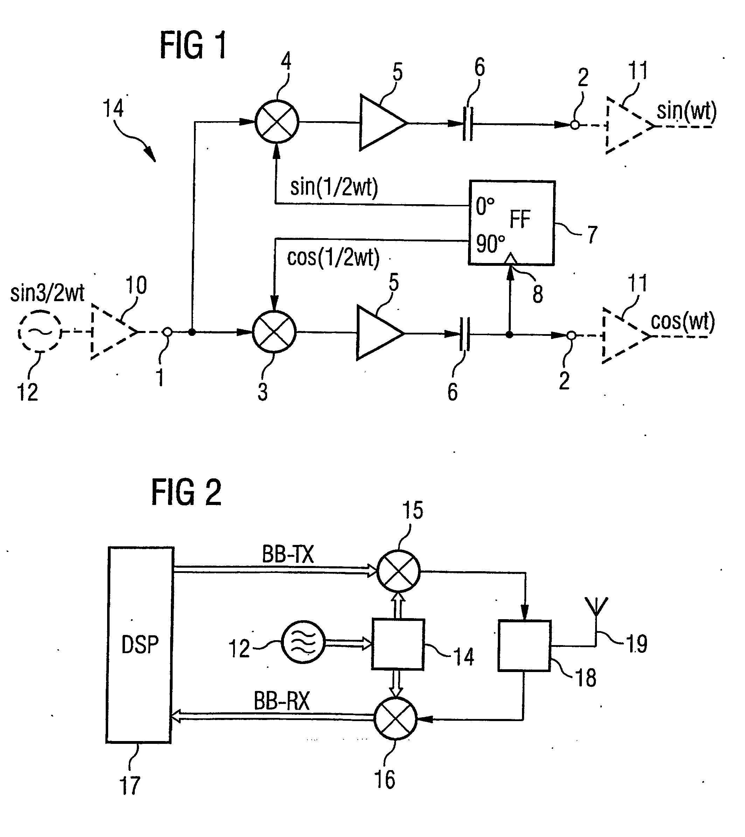

Figur 1 zeigt eine Schaltungsanordnung zur Frequenzumsetzung mit einem Eingang 1, ausgebildet als Single-ended-Eingang und ausgelegt zum Zuführen eines Eingangssignals sin(3/2ωt) mit einer Eingangsfrequenz und einen IQ-Ausgang 2, ausgelegt als Ausgangsklemmenpaar zum Abgreifen eines komplexwertigen Ausgangssignals sin ωt, cos ωt mit einer von der Eingangsfrequenz abhängigen Ausgangsfrequenz. Weiterhin sind ein erster Frequenzmischer 3 und ein zweiter Frequenzmischer 4 vorgesehen, welche als Aufwärts-Frequenzumsetzer ausgebildet sind. Die Frequenzmischer 3, 4 haben jeweils einen ersten Eingang, einen zweiten Eingang und einen Ausgang. Die ersten Eingänge der Frequenzmischer 3, 4 sind mit dem Eingang 1 der Schaltungsanordnung verbunden. Die zweiten Eingänge der Frequenzumsetzer 3, 4 sind an einen später näher beschriebenen Rückkopplungspfad angeschlossen. An die Ausgänge der Frequenzumsetzer 3, 4 ist je ein Pufferverstärker 5 mit nachgeschaltetem Serienkondensator 6 angeschlossen. An den Ausgang desjenigen Serienkondensators 6, der mit dem Frequenzmischer 3 gekoppelt ist, ist ein Flipflop-Baustein 7 mit seinem Takteingang 8 angeschlossen. Weiterhin ist der Ausgang des Serienkondensators 6, der mit dem Ausgang des ersten Frequenzmischers 3 gekoppelt ist, mit einer Ausgangsklemme des IQ-Ausgangs 2 verbunden. Der mit dem Ausgang des zweiten Frequenzumsetzers 4 gekoppelte Serienkondensator 6 ist ebenfalls mit einer Ausgangsklemme des IQ-Ausganges 2 der Frequenzumsetzungsschaltung verbunden. Das Flipflop 7, welches eine Frequenzteilung durch 2 bewirkt, weist zwei Ausgänge auf, welche als 0°-Ausgang und als 90°-Ausgang ausgebildet sind und ausgelegt sind zum Abgreifen von zwei zueinander um 90° phasenverschobenen Signalkomponenten. Je einer der beiden Ausgänge des Flipflops 7, welches als Frequenzteiler arbeitet, ist mit je einem zweiten Eingang der beiden Frequenzmischer 3, 4 verbunden.

Die insoweit beschriebene Schaltung zur Frequenzumsetzung zwischen Eingang 1 und Ausgang 2 ist mit Bezugszeichen 14 versehen. An den Eingang 1 ist zur Zuführung des Eingangssignals mit der Eingangsfrequenz sin(3/2ωt) ein Frequenzgeherator 12 angeschlossen, welcher ein entsprechendes Oszillatorsignal bereitstellt. Der als spannungsgesteuerter Oszillator 12 ausgebildete Frequenzgenerator ist mit seinem Ausgang über einen Pufferverstärker 10 an den Eingang 1 angeschlossen. An das Ausgangspaar 2 ist, beispielsweise über weitere Pufferverstärker 11, ein Frequenzumsetzer in einem Mobilfunkgerät angeschlossen, siehe hierzu später Figur 2.

An den Ausgängen 2 der Frequenzumsetzungsschaltung 14 ist ein Ausgangssignal mit der Ausgangskreisfrequenz ω ableitbar, so daß ein Inphase- und Quadraturzweig ein entsprechendes Sinus- und Cosinus-Signal abgeleitet werden können, welche durch die Darstellung Sinus(ωt) und Cosinus(ωt) beschrieben werden.
Die Frequenzmischer 3, 4 mischen je ein rückgekoppeltes Signal, welches vom Flipflop 7 bereitgestellt wird, mit dem Eingangssignal. Das rückgekoppelte Signal hat dabei die halbe Ausgangsfrequenz und wird in den Komponenten des komplexwertigen rückgekoppelten Signals beschrieben durch die Ausdrücke sin(1/2ωt) und cos(1/2ωt). Mischt man in den Frequenzmischern 3, 4 diese rückgekoppelten Signalanteile mit dem Eingangssignal, so ergeben sich an den Ausgängen der Frequenzmischer zum einen die gewünschten Frequenzen bei der Kreisfrequenz ω sowie zusätzlich unerwünschte Frequenzanteile bei der doppelten Kreisfrequenz 2ω, welche in einfacher Weise durch Tiefpaßfilter oder durch Ausbildung der Aufwärtsmischer als Spiegelfrequenz unterdrückende Mischer oder andere, einem Fachmann der Hochfrequenztechnik geläufige Maßnahmen problemlos unterdrückt werden können.

Aufgrund des einfachen Aufbaus ohne RC-Allpaß ist die vorliegende Frequenzumsetzungsschaltung gemäß Figur 1 mit geringer Stromaufnahme, hoher Frequenzgenauigkeit und weitgehender Unabhängigkeit von Prozeßtoleranzen herstellbar. Zudem ist die gewünschte Entkopplung von Ausgangsfrequenz und Eingangsfrequenz erzielt, welche Rückwirkungen der Ausgangsfrequenz auf den Oszillator 12 vermeidet. Die Stromaufnahme der Schaltung gemäß Figur 1 ist verhältnismäßig gering, da auf einen RC-Allpaß verzichtet werden kann.

Figur 2 zeigt ein Anwendungsbeispiel der Frequenzumsetzungsschaltung 14 von Figur 1 in einem Mobilfunkgerät. Das Mobilfunkgerät weist einen Sendezweig und einen Empfangszweig auf, wobei im Sendezweig ein Aufwärts-Frequenzumsetzer 15 und im Empfangszweig ein Abwärts-Frequenzumsetzer 16, jeweils ausgelegt zur Verarbeitung komplexwertiger Nutzsignale, vorgesehen sind. Im Sendezweig ist der Frequenzumsetzer 15 über einen Basis-Signalpfad an den Ausgang eines digitalen Signalprozessors 17 angeschlossen, der ein Modulationssignal BB-TX im Basisband bereitstellt. Der Ausgang des Frequenzumsetzers 15 ist mit einer Duplexeinheit 18 gekoppelt, welche an eine Antenne 19 angeschlossen ist. Weiterhin ist die Duplexeinheit 18 an den Eingang eines Abwärts-Frequenzumsetzers 16 im Empfangspfad angeschlossen, welcher wiederum über einen Basisband-Signalverarbeitungspfad an einen Eingang der digitalen signalprozessoreinheit 17 zur Zuführung eines demodulierten Basisband-Signals BB-RX angeschlossen ist. Die Frequenzumsetzer 15, 16 zur Verarbeitung der Nutzsignale haben jeweils einen Hilfseingang zum Zuführen eines Trägersignals beziehungsweise eines Lokaloszillatorsignals. Dieses wird von einem Frequenzgenerator 12 erzeugt und in der Schaltungsanordnung zur Frequenzumsetzung 14 aufbereitet. Hierfür ist der Eingang 1 der Frequenzaufbereitungsschaltung 14 mit dem Ausgang des Frequenzgenerators 12 gekoppelt. Der Ausgang 2 der Frequenzaufbereitungsschaltung 14 ist mit jeweils einem Hilfseingang der Frequenzmischer 15, 16 verbunden.

Aufgrund der geringen Stromaufnahme sowie der hohen Frequenzgenauigkeit und dem geringen Chipflächenbedarf der Frequenzmischer 3, 4 und der Tatsache, daß an diese geringe Linearitätsanforderungen gestellt werden, ist der Transceiver gemäß Figur 2 besonders gut für die Massenherstellung geeignet.

### Bezugszeichenliste.

- 1: Eingang
- 2: IQ-Ausgang
- 3: Frequenzmischer
- 4: Frequenzmischer
- 5: Verstärker
- 6: Kondensator
- 7: Frequenzteiler
- 8: Takteingang
- 10: Verstärker
- 11: Verstärker
- 12: VCO
- 14: Frequenzumsetzungsschaltung
- 15: Aufwärtsmischer
- 16: Abwärtsmischer
- 17: digitale Signalverarbeitung
- 18: Duplexeinheit
- 19: Antenne

## Patentansprüche

1. Schaltungsanordnung zur Frequenzumsetzung, aufweisend
- einen Eingang (1) zum Zuführen eines Eingangssignals mit einer Eingangsfrequenz,
- einen Ausgang (2), ausgelegt zum Abgreifen eines komplexwertigen Ausgangssignals mit einer von der Eingangsfrequenz abhängigen Ausgangsfrequenz, umfassend einen Inphase- und einen Quadraturzweig,
- einen ersten Frequenzmischer (3) mit einem ersten Eingang, der an den Eingang (1) der Schaltungsanordnung angeschlossen ist, mit einem zweiten Eingang und mit einem Ausgang, der mit dem Ausgang (2) der Schaltungsanordnung gekoppelt ist,
- einen zweiten Frequenzmischer (4) mit einem ersten Eingang, der an den Eingang (1) der Schaltungsanordnung angeschlossen ist, mit einem zweiten Eingang und mit einem Ausgang, der mit dem Ausgang (2) der Schaltungsanordnung gekoppelt ist, und
- einen Frequenzteiler (7) mit einem Eingang, der mit dem Ausgang des ersten Frequenzmischers (3) gekoppelt ist, mit einem Inphase-Ausgang, der mit dem zweiten Eingang des zweiten Frequenzmischers (4), und mit einem Quadratur-Ausgang, der mit dem zweiten Eingang des ersten Frequenzmischers (3) zur Zuführung je einer Signalkomponente eines Signals mit heruntergeteilter Ausgangsfrequenz gekoppelt ist.

2. Schaltungsanordnung nach Anspruch 1,
**dadurch gekennzeichnet, daß**
der Frequenzteiler (7) als Frequenzteiler mit dem Teilerfaktor zwei ausgebildet ist.

3. Schaltungsanordnung nach Anspruch 1 oder 2,
**dadurch gekennzeichnet, daß**
der Frequenzteiler (7) ein Flipflop umfaßt mit einem NullGrad- und mit einem 90-Grad-Ausgang, welche den Inphase- und den Quadratur-Ausgang des Frequenzteilers (7) bilden.

4. Schaltungsanordnung nach Anspruch 3,
**dadurch gekennzeichnet, daß**
das Flipflop einen Takteingang aufweist, der den Eingang des Frequenzteilers (7) bildet.

5. Schaltungsanordnung nach einem der Ansprüche 1 bis 4,
**dadurch gekennzeichnet, daß**
zwischen den Ausgang des ersten Frequenzmischers (3) und den Eingang des Frequenzteilers (7) ein Mittel zur Gleichanteilentkopplung (6) des Ausgangssignals der Schaltungsanordnung geschaltet ist.

6. Schaltungsanordnung nach einem der Ansprüche 1 bis 5,
**dadurch gekennzeichnet, daß**
an den Ausgang des zweiten Frequenzmischers (4) ein Mittel zur Gleichanteilentkopplung (6) des Ausgangssignals der Schaltungsanordnung geschaltet ist.

7. Schaltungsanordnung nach Anspruch 5 oder 6,
**dadurch gekennzeichnet, daß**
das Mittel zur Gleichanteilentkopplung (6) ein Kondensator ist.

8. Mobilfunkgerät mit einer Schaltungsanordnung mit den Merkmalen gemäß einem der Ansprüche 1 bis 7,
aufweisend
- zumindest eine Einrichtung zur Frequenzumsetzung (15, 16) eines Nutzsignals zwischen einem Basisband und einer hochfrequenten Lage mit einem Hilfseingang zum Zuführen eines komplexwertigen Signals mit einer Trägerfrequenz,
- einen Frequenzgenerator (12), der an einem Ausgang ein Bezugssignal mit einer Bezugsfrequenz bereitstellt, und
- die Schaltungsanordnung zur Frequenzumsetzung (14), die mit ihrem Eingang an den Ausgangs des Frequenzgenerators (12) und mit ihrem Ausgang mit dem Hilfseingang der Einrichtung zur Frequenzumsetzung (15, 16) gekoppelt ist.

## Claims

1. A frequency conversion circuit arrangement having
- an input (1) for supplying an input signal at an input frequency,
- an output (2) which is designed to tap off a complex output signal at an output frequency which is dependent on the input frequency and comprises an in-phase path and a quadrature path,
- a first frequency mixer (3) having a first input which is connected to the input (1) of the circuit arrangement, a second input and an output which is coupled to the output (2) of the circuit arrangement,
- a second frequency mixer (4) having a first input which is connected to the input (1) of the circuit arrangement, a second input and an output which is coupled to the output (2) of the circuit arrangement, and
- a frequency divider (7) having an input which is coupled to the output of the first frequency mixer (3), an in-phase output which is coupled to the second input of the second frequency mixer (4) and a quadrature output which is coupled to the second input of the first frequency mixer (3), for the purpose of supplying a respective signal component of a signal at a divided-down output frequency.

2. The circuit arrangement as claimed in claim 1,
**characterized in that**
the frequency divider (7) is in the form of a frequency divider having a division factor of two.

3. The circuit arrangement as claimed in claim 1 or 2,
**characterized in that**
the frequency divider (7) comprises a flip-flop having a zero degree output and a 90 degree output which form the in-phase and quadrature outputs of the frequency divider (7).

4. The circuit arrangement as claimed in claim 3,
**characterized in that**
the flip-flop has a clock input which forms the input of the frequency divider (7).

5. The circuit arrangement as claimed in one of claims 1 to 4,
**characterized in that**
a means (6) for decoupling the DC component(s) of the output signal of the circuit arrangement is connected between the output of the first frequency mixer (3) and the input of the frequency divider (7).

6. The circuit arrangement as claimed in one of claims 1 to 5,
**characterized in that**
a means (6) for decoupling the DC component(s) of the output signal of the circuit arrangement is connected to the output of the second frequency mixer (4).

7. The circuit arrangement as claimed in claim 5 or 6,
**characterized in that**
the means (6) for decoupling the DC component(s) is a capacitor.

8. A mobile radio having a circuit arrangement with the features claimed in one of claims 1 to 7,
having
- at least one device (15, 16) which is intended to convert the frequency of a wanted signal between baseband and a radio frequency and has an auxiliary input for the purpose of supplying a complex signal at a carrier frequency,
- a frequency generator (12) which provides a reference signal at a reference frequency at an output, and
- the frequency conversion circuit arrangement (14) whose input is coupled to the output of the frequency generator (12) and whose output is coupled to the auxiliary input of the frequency conversion device (15, 16).

## Revendications

1. Circuit de conversion de fréquence comprenant
- une entrée (1) pour faire entrer un signal d'entrée ayant une fréquence d'entrée,
- une sortie (2) conçue pour prélever un signal de sortie à valeur complexe, ayant une fréquence de sortie qui dépend de la fréquence d'entrée, comprenant une branche en phase et une branche en quadrature,
- un premier mélangeur (3) de fréquence ayant une première entrée qui est raccordée à l'entrée (1) du circuit et ayant une deuxième entrée et une sortie qui est couplée à la sortie (2) du circuit,
- un deuxième mélangeur (4) de fréquence ayant une première entrée qui est raccordée à l'entrée (1) du circuit et ayant une deuxième entrée et une sortie qui est couplée à la sortie (2) du circuit, et
- un diviseur (7) de fréquence ayant une entrée qui est couplée à la sortie du premier mélangeur (3) de fréquence et ayant une sortie en phase qui est couplée à la deuxième entrée du deuxième mélangeur (4) de fréquence et ayant une sortie en quadrature qui est couplée à la deuxième entrée du premier mélangeur (3) de fréquence pour faire entrer respectivement une composante d'un signal dont la fréquence de sortie a été abaissée par division.

2. Circuit suivant la revendication 1,
**caractérisé en ce que**
le diviseur (7) de fréquence est constitué en diviseur de fréquence par le facteur de division deux.

3. Circuit suivant la revendication 1 ou 2,
**caractérisé en ce que**
le diviseur (7) de fréquence comprend une bascule ayant une sortie à zéro degré et une sortie à 90 degré, qui forment la sortie en phase et la sortie en quadrature du diviseur (7) de fréquence.

4. Circuit suivant la revendication 3,
**caractérisé en ce que**
la bascule a une entrée d'horloge, qui forme l'entrée du diviseur (7) de fréquence.

5. Circuit suivant l'une des revendications 1 à 4,
**caractérisé en ce qu'**
entre la sortie du premier mélangeur (3) de fréquence et l'entrée du diviseur (7) de fréquence est monté un moyen de découplage (6) de la partie continue du signal de sortie du circuit.

6. Circuit suivant l'une des revendications 1 à 5,
**caractérisé en ce que**
à la sortie du deuxième mélangeur (4) de fréquence est monté un moyen de découplage (6) de la partie continue du signal de sortie du circuit.

7. Circuit suivant la revendication 5 ou 6,
**caractérisé en ce que**
les moyens de découplage (6) de la partie continue sont un condensateur.

8. Appareil de téléphonie mobile comprenant un circuit ayant les caractéristiques suivant l'une des revendications 1 à 7,
comprenant
- au moins un dispositif de conversion (15, 16) de fréquence d'un signal utile entre une bande de base et une position en haute fréquence, comprenant une entrée auxiliaire pour faire entrer un signal à valeur complexe ayant une fréquence porteuse,
- un générateur (12) de fréquence, qui met à disposition à une sortie un signal de référence ayant une fréquence de référence, et
- le circuit de conversion (14) de fréquence, qui est couplé par son entrée à la sortie du générateur (12) de fréquence et par sa sortie à l'entrée auxiliaire du dispositif de conversion (15, 16) de fréquence.
